# EUROPEAN PATENT APPLICATION

(11) **EP 2 204 818 A2**
(43) Date of publication of application: **07.07.2010**
(21) Application number: 09252883.5
(22) Date of filing: 22.12.2009
(51) Int. Cl.: G11C 29/50, G11C 29/00, G11C 29/46

(54) **Enabling an integrated memory controller to transparently work with defective memory devices**

(30) Priority: 30.12.2008 US 345948
(71) Applicant: Intel Corporation, Santa Clara, CA 95052 (US)
(72) Inventor: Datta, Shamanna M., Hillsboro, Oregon 97124 (US); Alexander, James W., Hillsboro, Oregon 97123 (US)
(74) Representative: Beresford, Keith Denis Lewis

(57) **Abstract**

Embodiments of the invention are generally directed to systems, methods, and apparatuses for enabling an integrated memory controller to transparently work with defective memory devices. In some embodiments, a marginal condition is imposed on a memory module during normal operations of the memory module. The term "marginal condition" refers to a condition that is out of compliance with a specified (or "normal") operating condition for the memory module. The memory module may exhibit failures in response to the marginal conditions and compensating mechanisms may mitigate the failures.

## Description

### TECHNICAL FIELD

Embodiments of the invention generally relate to the field of integrated circuits and, more particularly, to systems, methods and apparatuses for enabling an integrated memory controller to transparently work with defective memory devices.

### BACKGROUND

The density of dynamic random access memory devices (DRAMs) has been growing at a substantial rate. In addition, the number of DRAMs on a memory module (and the number of memory modules in a computing system) has also been growing at a substantial rate. All of these manufactured components are subject to the same statistical yield patterns, and this means that as the DRAM density increases there is a corresponding increase in the risk of defective bits in the manufactured components. Current yields for DRAMs are around 90%. The components with defective bits are binned and sold as lower density chips if possible. On the other hand, the ever increasing memory footprint of computer operating systems and data processing needs continues to drive the need for larger memory subsystems in computing systems. In almost all segments the memory subsystem cost is becoming a significant part of the total cost of a computing system.

### BRIEF DESCRIPTION OF THE DRAWINGS

Embodiments of the invention are illustrated by way of example, and not by way of limitation, in the figures of the accompanying drawings in which like reference numerals refer to similar elements.

**Figure 1** is a high-level block diagram illustrating selected aspects of a computing system implemented according to an embodiment of the invention.

**Figure 2** is a block diagram illustrating selected aspects of logic to impose a marginal condition on a memory module and to compensate for the imposed marginal condition.

**Figure 3** is a flow diagram illustrating selected aspects of a method for operating a memory module according to an embodiment of the invention.

**Figures 4** is a flow diagram illustrating selected aspects of a method for compensating for a marginal condition imposed on a memory module according to an embodiment of the invention.

### DETAILED DESCRIPTION

Embodiments of the invention are generally directed to systems, methods, and apparatuses for enabling an integrated memory controller to transparently work with defective memory devices. In some embodiments, a marginal condition is imposed on a memory module during normal operations of the memory module. The term "marginal condition" refers to a condition that is out of compliance with a specified (or "normal") operating condition for the memory module. The memory module may exhibit failures in response to the marginal conditions and compensating mechanisms may mitigate the failures.

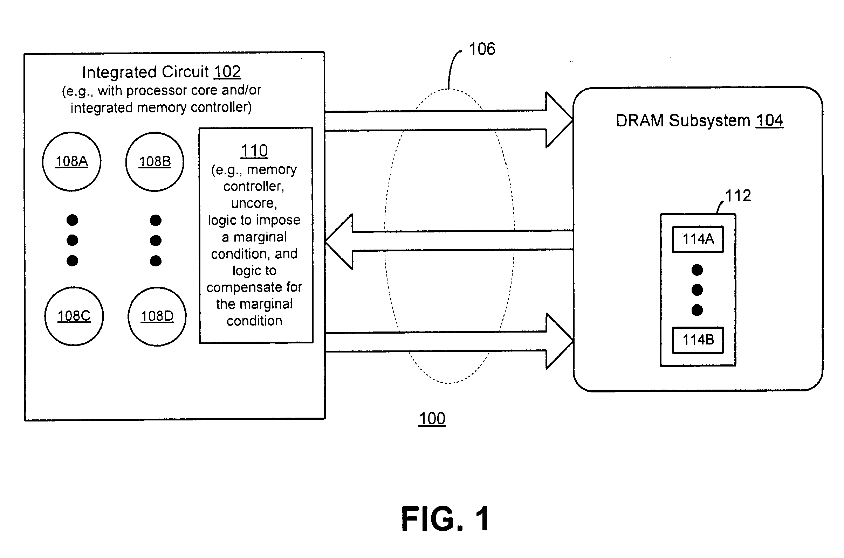

FIG. 1 is a high-level block diagram illustrating selected aspects of a computing system implemented according to an embodiment of the invention. System 100 includes integrated circuit 102, DRAM subsystem 104, and memory interconnect 106. In alternative embodiments, system 100 may include more elements, fewer elements, and/or different elements.

Integrated circuit 102 includes logic to control the transfer of information with DRAM subsystem 104. In the illustrated embodiment, integrated circuit 102 includes processor cores 108 and logic 110. Processor cores 108 may be any of a wide range of processor cores including general processor cores, graphics processor cores, and the like. Logic 110 broadly represents a wide array of logic including, for example, a memory controller, an uncore, and the like.

In some embodiments, logic 110 also includes logic to impose a marginal condition on a memory module (or on another element of DRAM subsystem 104) and logic to compensate for the imposed marginal condition. The term "marginal condition" broadly refers to a condition that exceeds the bounds of normal operating conditions as defined by a (public or proprietary) specification, standard, protocol, and the like. For example, normal operating conditions for voltage, temperature, and refresh rate are typically defined for a memory module in a specification or standard. The phrase "imposing a marginal condition" refers to operating the device (e.g., the memory module) outside of the range of values that are considered "normal" for the device.

In some embodiments, "imposing a marginal condition" refers to imposing a voltage, a temperature, and/or a refresh rate that is outside of values that are considered "normal" (e.g., as defined by a specification, a standard, or the like). For example, in some embodiments, logic 110 imposes a refresh rate that is lower than the refresh rate specified for memory module 112. The advantages to imposing a lower refresh rate include an improvement in overall system performance since the system is spending less time with its memory in refresh. In addition, the power consumed by DRAM subsystem 104 may be reduced by reducing the refresh rate. Similarly, operating under lower voltage can yield power savings. In alternative embodiments, logic 110 may impose a different marginal condition on memory module 112 (and/or any other element of DRAM subsystem 104 and/or on interconnect 106).

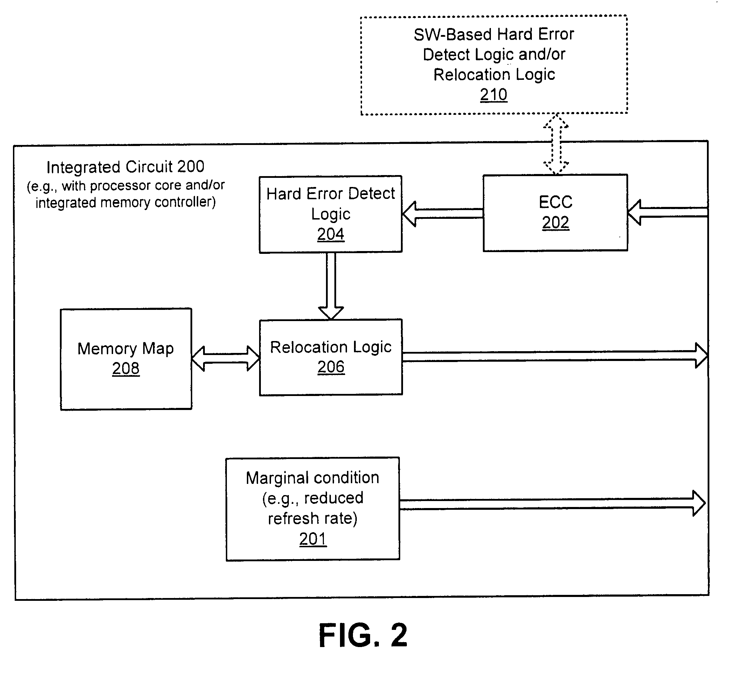

The phrase "compensating for the imposed marginal condition" refers to detecting a change in the performance of DRAM subsystem 104 and/or compensating for those changes. For example, in some embodiments, logic 110 imposes a reduced refresh rate on memory module 112. Some of the memory locations in module 112 may exhibit defects in response to the reduced refresh rate. Logic 110 may detect those defects and compensate for them. For example, in some embodiments, logic 110 may move information that is stored in the "defective" memory locations to another location (e.g., one that is known to be operating properly). Aspects of logic 110 are further discussed below with reference to FIGs. 2-4.

DRAM subsystem 104 provides at least a portion of the main memory for system 100. In the illustrated embodiment, DRAM subsystem 104 includes one or more memory modules 112. Modules 112 may be any of a wide range of memory modules including dual inline memory modules (DIMMs), small outline DIMMs (SO-DIMMs), and the like. Each module 112 may have one or more DRAMs 114 (and possibly other elements such as registers, buffers, and the like). DRAMs 114 may be any of a wide range of devices including nearly any generation of double data rate (DDR) DRAMs.

The embodiment illustrated in FIG. 1 shows an integrated memory controller (e.g., integrated with the processor). It is to be appreciated, however, that in some embodiments the memory controller may be part of the chipset for computing system 100. In such embodiments, the logic to impose marginal conditions and the logic to compensate for marginal conditions may also be part of the computing system.

FIG. 2 is a block diagram illustrating selected aspects of logic to impose a marginal condition on a memory module and logic to compensate for the imposed marginal condition. In the illustrated embodiment, integrated circuit 200 includes marginal condition logic 201, error correction code (ECC) 202, hard error detect logic 204, relocation logic 206, and memory map 208. In alternative embodiments, integrated circuit 200 may include more elements, fewer elements, and/or different elements.

Marginal condition logic 201 includes logic to impose a marginal condition on one or more elements of a DRAM subsystem (e.g., DRAM subsystem 204 shown in FIG. 2). In some embodiments, logic 201 includes logic to operate one or more memory modules at a reduced refresh rate. In other embodiments, logic 201 includes logic to impose a marginal voltage and/or a marginal temperature on the memory subsystem. In yet other embodiments, logic 201 may impose a different marginal condition on one or more elements of the DRAM subsystem.

ECC logic 202 includes logic to detect and correct selected errors in information (e.g., data and/or code) that is read from the DRAM subsystem (e.g., DRAM subsystem 104, shown in FIG. 1). For example, ECC logic 202 may be coupled with (selected portions) of the memory interconnect (e.g., interconnect 106, shown in FIG. 1). As data arrives over the interconnect (from the memory module) ECC 202 checks for errors in the data. ECC 202 may use any of a wide range of algorithms to check the data (e.g., parity, single error correct - double error detect (SECDEC), Chipkill, and the like). In some embodiments, if ECC 202 detects an error, then it forwards information about the error to logic 204.

In some embodiments, hard error detect logic 204 determines whether a detected error is a hard error or a soft error. The term "soft error" refers to an error in stored information that is not the result of a hardware defect (e.g., an error due to an alpha strike). A "hard error" refers to an error that is due to a hardware defect. For example, bits that go bad due to a memory module operating in a marginal condition are hard errors. In some embodiments, logic 204 determines whether there are hard errors based on whether the error is persistent. For example, logic 204 may use replay logic to write to and read from a memory location a number of times to determine whether one or more bits are persistently bad. The replay logic may be preexisting replay logic (e.g., in a memory controller) or it may replay logic that is part of logic 204.

In some embodiment, if logic 204 detects a "hard error" then relocation logic 206 moves the information stored in the defective memory location to another memory location (e.g., a reserved memory location that is operating normally). As used herein, the term "relocation" refers to moving information from a defective region to a known good region. Relocation may also include building and using memory map 208. For example, the process flow for relocation may include changing a pointer, changing a table entry, and the like. Memory map 208 is a logical structure that provides a mapping to relocated information and/or provides an indication of which memory locations are currently defective. Memory map 208 may be built and used during the normal operation of a system (e.g., during real time rather than manufacture time). As defective locations are identified and information is relocated, logic 206 builds and uses memory map 208. Relocation is performed before the "hard" error leads to a system failure or data corruption.

In some embodiments, at least a portion of the logic to compensate for the marginal condition is, optionally, performed in software. For example, some or all of the tasks associated with detecting a hard error, relocating information, and/or building/using a memory map may be performed by software 210. In some embodiments software 210 is a handler such as a system management interrupt handler (e.g., an SMI handler). In other embodiments, software 210 may be part of the operating system (OS) kernel.

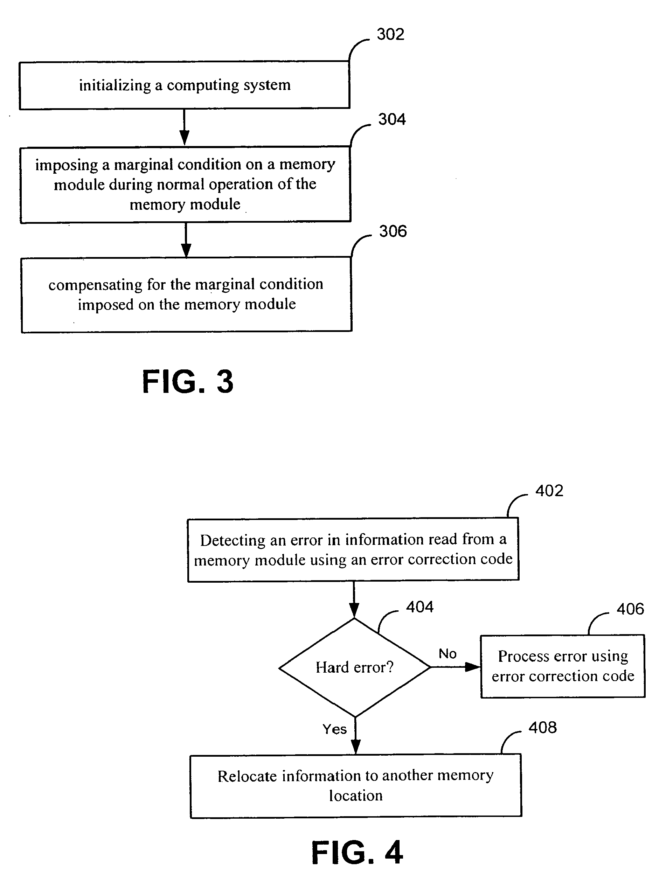

FIG. 3 is a flow diagram illustrating selected aspects of a method for operating a memory module according to an embodiment of the invention. In some embodiments, the process flow illustrated in FIG. 3 may be performed by a computing system such as system 100 illustrated in FIG. 1. Referring to process block 302, the computing system is initialized. The term "initialization" refers to, for example, booting, rebooting, starting, powering-up and the like.

Marginal condition logic (e.g., logic 201 or other logic) imposes a marginal condition at 304. In some embodiments, the marginal condition is a reduced refresh rate. In other embodiments, the marginal condition is a marginal operating voltage and/or a marginal temperature. In yet other embodiments, the marginal condition may be nearly any other condition that is in variance with the "normal" operating conditions for the DRAM subsystem.

Logic to compensate for the marginal condition performs an action at 306. In some embodiments, compensating for the marginal condition includes detecting hard errors and relocating information to a known good memory location. In some embodiments, the compensating logic uses a memory map to reference the new locations for the relocated data.

FIG. 4 is a flow diagram illustrating selected aspects of a method for detecting and compensating for a marginal condition imposed on a memory module according to an embodiment of the invention. In some embodiments, the process shown in FIG. 4 is performed by hardware (e.g., by elements of integrated circuit 200, shown in FIG. 2). In other embodiments, the process (or portions of the process) may be performed by software (e.g., software 210, shown in FIG. 2).

Referring to process block 402, an ECC code (e.g., ECC 202, shown in FIG. 2) detects an error in information read from a memory module. The ECC code may use any of a wide range of algorithms including parity, SECDED, Chipkill, and the like. If the ECC code detects an error, hard error detection logic determines whether the detected error is a hard error or a soft error at 404. In some embodiments, an error is a considered a hard error if it is persistent. If the hard error detection logic determines that the error is not a hard error, then the error is processed by the ECC code in the conventional manner as shown by 406.

If a hard error is detected, then relocation logic may move the data currently located in the "defective" memory location to a known good location (408). In some embodiments, the relocation logic may reserve one or more "spare" memory locations (e.g., rows, portions of rows, ranks, and the like) that are functioning normally. When a hard error is detected, the information in the defective memory locations may be moved to one of the spare locations. In some embodiments, the relocation logic uses a memory map to reference the new locations for the relocated data and to indicate where the defective locations are.

Elements of embodiments of the present invention may also be provided as a machine-readable medium for storing the machine-executable instructions. The machine-readable medium may include, but is not limited to, flash memory, optical disks, compact disks-read only memory (CD-ROM), digital versatile/video disks (DVD) ROM, random access memory (RAM), erasable programmable read-only memory (EPROM), electrically erasable programmable read-only memory (EEPROM), magnetic or optical cards, propagation media or other type of machine-readable media suitable for storing electronic instructions. For example, embodiments of the invention may be downloaded as a computer program which may be transferred from a remote computer (e.g., a server) to a requesting computer (e.g., a client) by way of data signals embodied in a carrier wave or other propagation medium via a communication link (e.g., a modem or network connection).

In the description above, certain terminology is used to describe embodiments of the invention. For example, the term "logic" is representative of hardware, firmware, software (or any combination thereof) to perform one or more functions. For instance, examples of "hardware" include, but are not limited to, an integrated circuit, a finite state machine, or even combinatorial logic. The integrated circuit may take the form of a processor such as a microprocessor, an application specific integrated circuit, a digital signal processor, a micro-controller, or the like.

It should be appreciated that reference throughout this specification to "one embodiment" or "an embodiment" means that a particular feature, structure or characteristic described in connection with the embodiment is included in at least one embodiment of the present invention. Therefore, it is emphasized and should be appreciated that two or more references to "an embodiment" or "one embodiment" or "an alternative embodiment" in various portions of this specification are not necessarily all referring to the same embodiment. Furthermore, the particular features, structures or characteristics may be combined as suitable in one or more embodiments of the invention.

Similarly, it should be appreciated that in the foregoing description of embodiments of the invention, various features are sometimes grouped together in a single embodiment, figure, or description thereof for the purpose of streamlining the disclosure aiding in the understanding of one or more of the various inventive aspects. This method of disclosure, however, is not to be interpreted as reflecting an intention that the claimed subject matter requires more features than are expressly recited in each claim. Rather, as the following claims reflect, inventive aspects lie in less than all features of a single foregoing disclosed embodiment. Thus, the claims following the detailed description are hereby expressly incorporated into this detailed description.

## Claims

1. An integrated circuit comprising:
a first logic to impose a marginal condition on a memory module during normal operation of the memory module, wherein the memory module is to be coupled with the first logic; and
a second logic to compensate for the marginal condition imposed on the memory module.

2. The integrated circuit of claim 1, wherein the marginal condition is a marginal operating voltage.

3. The integrated circuit of claim 1, wherein the marginal condition is a marginal operating temperature.

4. The integrated circuit of claim 1, wherein the marginal condition is a marginal refresh rate.

5. The integrated circuit of claim 4, wherein the second logic is logic to compensate for the marginal refresh rate.

6. The integrated circuit of claim 5, wherein the second logic includes hard error detection logic to detect a hard error associated with a memory location on the memory module.

7. The integrated circuit of claim 6, wherein the second logic further includes relocation logic to relocate data away from the memory location.

8. The integrated circuit of claim 7, further comprising:
error correction logic coupled with the second logic, the error correction logic to detect errors in information stored on the memory module.

9. The integrated circuit of claim 1, further comprising:
one or more processor cores.

10. The integrated circuit of claim 9, further comprising:
a memory controller to control the transfer of information with the memory module.

11. A system comprising:
said memory module to provide at least a portion of main memory for a computing system; and
an integrated circuit as claimed in any preceding claim, coupled with the memory module via a memory interconnect.

12. A method comprising:
initializing a computing system;
imposing a marginal condition on a memory module during normal operation of the memory module; and
compensating for the marginal condition imposed on the memory module.

13. The method of claim 11, wherein the marginal condition is a marginal operating voltage.

14. The method of claim 11, wherein the marginal condition is a marginal operating temperature.

15. The method of claim 11, wherein the marginal condition is a marginal refresh rate.

16. The method of claim 14, wherein compensating for the marginal condition imposed on the memory module comprises:
detecting a hard error associated with a memory location on the memory module.

17. The method of claim 15, wherein detecting a hard error associated with a memory location on the memory module comprises:
detecting an error in information read from the memory location using error correction logic; and
determining whether the detected error is a hard error or a soft error.

18. The method of claim 16, wherein determining whether the detected error is a hard error or a soft error comprises:
determining whether the error is persistent.

19. The method of claim 15, wherein compensating for the marginal condition imposed on the memory module further comprises:
relocating information from the memory location to another memory location.
